# EUROPEAN PATENT SPECIFICATION

(11) **EP 3 297 163 B1**
(45) Date of publication and mention of the grant of the patent: **11.03.2020**
(21) Application number: 15895261.4
(22) Date of filing: 19.06.2015
(51) Int. Cl.: H03K 17/96, H03K 17/965

(54) **USER EQUIPMENT**
BENUTZERAUSRÜSTUNG
ÉQUIPEMENT D'UTILISATEUR

(43) Date of publication of application: 21.03.2018
(73) Proprietor: Huawei Technologies Co., Ltd., Longgang District Shenzhen, Guangdong 518129 (CN)
(72) Inventor: CHU, Jianfei, Shenzhen Guangdong 518129 (CN); XIE, Hui, Shenzhen Guangdong 518129 (CN); WANG, Xiaoyang, Shenzhen Guangdong 518129 (CN); SHUAI, Junqing, Shenzhen Guangdong 518129 (CN)
(74) Representative: Gill Jennings & Every LLP
(86) International application number: PCT/CN2015/081898
(87) International publication number: WO 2016/201688

(56) References cited:
- WO-A1-2014/037765
- CN-A- 101 741 370
- CN-A- 103 501 375
- CN-A- 104 049 717
- CN-U- 202 524 452
- DE-A1-102008 061 715
- JP-A- 2005 300 030
- US-A1- 2010 054 493

## Description

### TECHNICAL FIELD

Embodiments of present invention relate to the field of communications technologies, and in particular, to user equipment.

### BACKGROUND

With constant development of user equipment, people require higher voice call quality. Currently, the user equipment, for example, a smartphone, usually collects a voice by using a microphone (Microphone, MIC for short). The microphone is usually disposed at a lower position on a front side of the user equipment. As a result, the microphone is easily blocked by a finger when people are talking during a voice call, and a voice heard by the other party is relatively low, or even the other party cannot hear a voice clearly.

On the user equipment in the prior art, an expansion groove is disposed at an outer opening of the microphone, which is equivalent to expanding an external opening of a voice transmitting hole of the microphone. By means of such structural reformation, a function of anti-blocking is achieved. However, such structural reformation only reduces a microphone blocking rate, and does not resolve the problem of microphone blocking thoroughly.

WO 2014/037765 relates to detection of a microphone impairment and automatic microphone switching.

### SUMMARY

The present invention provides user equipment, so as to reliably detect whether a microphone is blocked.

Various aspects of the present disclosure have been defined in the independent claims. Further technical features of each of these aspects have been defined in the respective dependent claims.

Embodiments of the present invention provide user equipment, including: a capacitance detection apparatus, a control unit, a microphone, and a prompt apparatus, where the capacitance detection apparatus includes a touch control unit and a capacitance detection unit; the touch control unit is configured to sense a capacitance change of a touch area in which the touch control unit is located, and the microphone is located in the touch area; the capacitance detection unit is electrically connected to the touch control unit, and the capacitance detection unit measures a capacitance value of the touch area according to the capacitance change sensed by the touch control unit, and sends the capacitance value to the control unit; and if the control unit determines that the capacitance value is greater than or equal to a first preset value, the control unit determines that the microphone is blocked, and controls the prompt apparatus to send prompt information. The user equipment determines accurately, according to the measured capacitance value, whether the microphone is blocked, thereby making an ongoing voice call smoother.

The scope of the invention is defined in the appended claims. Any reference to "embodiment(s)", "example(s)" or "aspect(s) of the invention" in this description not falling under the scope of the claims should be interpreted as illustrative example(s) for understanding the invention.

### BRIEF DESCRIPTION OF DRAWINGS

To clearly describe technical solutions of embodiments of the present invention or technical solutions in the prior art, the following simply describes accompanying drawings needed to be used in the description of the embodiments or the prior art. Apparently, the accompanying drawings in the following descriptions are merely some embodiments of the present invention. Other accompanying drawings can be acquired according to these accompanying drawings by a person of ordinary skill in the prior art without making any creative efforts.
FIG. 1 is a schematic diagram of cooperative use of a capacitance detection apparatus and a microphone according to an example;
FIG. 2 is a schematic structural diagram of the capacitance detection apparatus according to an example;
FIG. 3 is a block diagram of a capacitance sensing principle according an example;
FIG. 4 is a schematic structural diagram of a capacitance detection apparatus according to an embodiment of the present invention;
FIG. 5 is a block diagram of a principle of sharing a same touchscreen chip according to an embodiment of the present invention;
FIG. 6 is a schematic diagram of cooperative use of a switch apparatus and a microphone according to an embodiment of the present invention; and
FIG. 7 is a diagram of a principle of detecting microphone blocking by using a switch apparatus according to an embodiment of the present invention.

### DESCRIPTION OF EMBODIMENTS

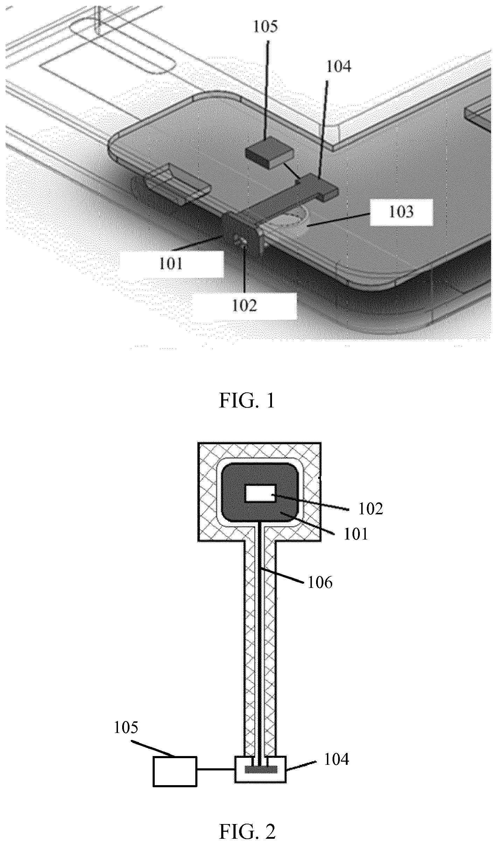

To resolve a problem of microphone blocking on user equipment in the prior art, the embodiments of the present invention provide user equipment. The user equipment is applied to a scenario in which a user uses the user equipment to make a call with a finger, a face or the like blocking a microphone. The user equipment may be a smartphone, a tablet computer or the like. The user equipment includes a capacitance detection apparatus, a control unit, a microphone, and a prompt apparatus. The capacitance detection apparatus includes a touch control unit and a capacitance detection unit. Two ends of the capacitance detection unit are separately electrically connected to the touch control unit and the control unit. FIG. 1 is a schematic diagram of cooperative use of a capacitance detection apparatus and a microphone according to an example. As shown in FIG. 1, an open hole 102 is formed on a touch control unit 101. The open hole 102 is aligned to a voice transmitting hole of the microphone 103, that is, the touch control unit 101 corresponds to the microphone 103. The touch control unit 101 is electrically connected to a capacitance detection unit 105 by using a first connector 104.

The following describes a specific structure of the capacitance detection apparatus.

FIG. 2 is a schematic structural diagram of the capacitance detection apparatus according to an example. The capacitance detection apparatus includes the touch control unit 101 and the capacitance detection unit 105. Referring to FIG. 1 and FIG. 2, a process of detecting microphone blocking by the capacitance detection apparatus is: After a finger touches the touch control unit 101, the touch control unit 101 senses a capacitance change of a touch area in which the touch control unit 101 is located. In this case, the capacitance detection unit 105 measures a capacitance value of the touch area according to the capacitance change sensed by the touch control unit 101, and sends the measured capacitance value to the control unit. If the control unit determines that the capacitance value is greater than or equal to a first preset value, the control unit determines that an object has touched the touch control unit. Because the microphone 103 is located in the touch area, it indicates that the object has blocked the microphone 103, and the control unit controls the prompt apparatus to send prompt information. Further, as shown in FIG. 2, the touch control unit 101 is electrically connected to the capacitance detection unit 105 by using the first connector 104, and a specific connection manner may be: One end of the first connector 104 is connected to the touch control unit 101 by using a connection line 106, and the other end of the first connector 104 is electrically connected to a second connector on a mainboard of the user equipment. The open hole 102 is formed on the touch control unit 101. The touch control unit 101, the connection line 106 and the first connector 104 are laid on a flexible circuit board. The capacitance detection unit 105 is electrically connected to the second connector. To reduce parasitic capacitance generated by another connection line, the capacitance detection unit 105 and the flexible circuit board should be as close to each other as possible. Further, because an interference source is formed by a rectangle shape with sharp corners concentrating magnetic fields, the touch control unit 101 provided in this example is of a rectangle shape with round corners. The touch control unit 101 is connected to the first connector 104 on the flexible circuit board by using the connection line 106, and ground wiring processing is performed around by using a grid. A double-sided tape is glued on a rear side of the flexible circuit board, so that when being installed, the flexible circuit board may be glued on an inner side of a rear housing of a smartphone, and located between a rubber sleeve of a smartphone microphone and the rear housing of the smartphone. In this way, exterior appearance of the smartphone is not affected, a good anti-electrostatic discharge (Electro-Static discharge, ESD for short) capability is achieved, and the touch control unit 101 may correspond to the microphone because the flexible circuit board can be deformed according to a need.

Optionally, the prompt apparatus includes at least one of a speaker, a vibrator or a display screen on the user equipment. Therefore, the prompt information may be correspondingly a voice prompt, a vibration prompt, a text prompt or the like. For example, the voice information may be: "Attention, the microphone is blocked". It should be readily understood that the control unit may be a central processing unit (Central Processing Unit, CPU for short).

The touch control unit in this example not belonging to the invention may be a metallic coil made of a metallic material. For example, the touch control unit may be a copper coil. Connectors configured to transmit currents or signals all may be used as the first connector and the second connector as long as they can connect two active devices. Certainly, another component that can generate a capacitance change, for example, a touchpad, may be used. According to the invention, the capacitance detection unit is a touchscreen chip.

This example provides user equipment, including: a capacitance detection apparatus, a control unit, a microphone, and a prompt apparatus, where the capacitance detection apparatus includes a touch control unit and a capacitance detection unit; the touch control unit is configured to sense a capacitance change of a touch area in which the touch control unit is located, and the microphone is located in the touch area; the capacitance detection unit is electrically connected to the touch control unit, and the capacitance detection unit measures a capacitance value of the touch area according to the capacitance change sensed by the touch control unit, and sends the capacitance value to the control unit; and the control unit determines whether the capacitance value is greater than or equal to a first preset value, and if yes, determines that the microphone is blocked, and controls the prompt apparatus to send prompt information. In this way, a problem of microphone blocking is thoroughly resolved, making an ongoing voice call smoother.

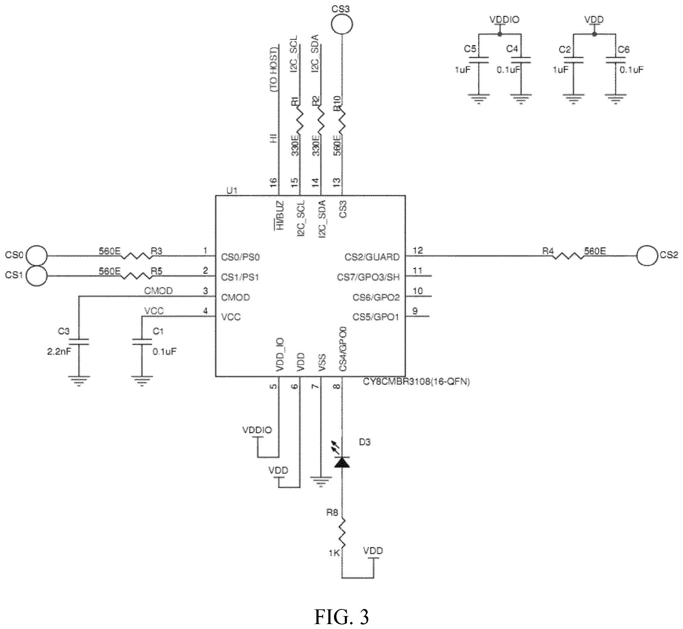

FIG. 3 is a block diagram of a capacitance sensing principle according to an example. A model of a chip in FIG. 3 is: CY8CMBR3108. The chip may be used as the capacitance detection unit described in FIG. 1 and FIG. 2. As shown in FIG. 3, CS0, CS1 and CS2 represent touch control units, and are respectively electrically connected to the chip CY8CMBR3108 by using pins CS0/PS0, CS1/PS1 and CS2/PS2. I2C_SCL and I2C_SDA are 12C signals in communication with a control unit, and TO_HOST is an interrupt signal in communication with the control unit. When a finger touches the touch control unit CS0, CS1 or CS2, the CY8CMBR3108 measures a capacitance value. When finding that the capacitance value increases, CY8CMBR3108 notifies the control unit by using the interrupt signal TO HOST, and exchanges information with the control unit by using an inter-integrated circuit (Inter-Integrated Circuit, IIC for short) bus, for example, sends the measured capacitance value to the control unit. The control unit determines whether the capacitance value is greater than or equal to a first preset value, and if yes, the control unit controls a prompt apparatus to send prompt information to a user.

Based on the capacitance sensing principle, an embodiment of the present invention further provides a capacitance detection apparatus, and details are as follows:

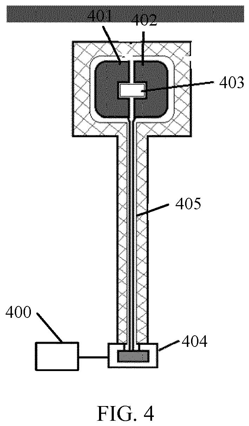

FIG. 4 is a schematic structural diagram of a capacitance detection apparatus according to an embodiment of the present invention. As shown in FIG. 4, the capacitance detection apparatus includes a touch control unit and a capacitance detection unit 400. The touch control unit includes a first touch control part 401 and a second touch control part 402. The first touch control part 401 and the second touch control part 402 are disposed facing each other to form an open hole 403. The open hole 403 is aligned to a voice transmitting hole of a microphone. Further, the capacitance detection unit 400 is a touchscreen chip. A transmit end of the touchscreen chip is electrically connected to the first touch control part, and a receive end of the touchscreen chip is electrically connected to the second touch control part. Cooperative use of the capacitance detection apparatus and the microphone is similar to that shown in FIG. 1. The first touch control part 401 and the second touch control part 402 are configured to sense a capacitance change of a touch area. One end of the first connector 404 is connected to the first touch control part 401 and the second touch control part 402 by using two connection lines 405, and the other end of the first connector 404 is electrically connected to a second connector on a mainboard of the user equipment. The first touch control part 401, the second touch control part 402, the first connector 404 and the two connection lines 405 are laid on a flexible circuit board. The capacitance detection unit 400 is electrically connected to the second connector. The capacitance detection unit 400, that is, the touchscreen chip, includes at least one transmit end (Transmit, TX for short) and at least one receive end (Receive, RX for short). The transmit end TX is connected to the first touch control part 401 by using the second connector, the first connector 404 and a connection line 405 in sequence, and the receive end RX is connected to the second touch control part 402 by using the second connector, the first connector 404 and a connection line 405 in sequence. The transmit end and the receive end are independent from other transmit ends and receive ends of the touchscreen chip.

The first touch control part and the second touch control part in this embodiment of the present invention may be made of metal wires, and may be each made into a semicircle shape, so that an open hole is formed between them. Similarly, other components that can generate a capacitance values may be used. Connectors configured to transmit currents or signals all may be used as the first connector and the second connector as long as they can connect two active devices. The connection lines may be copper wires.

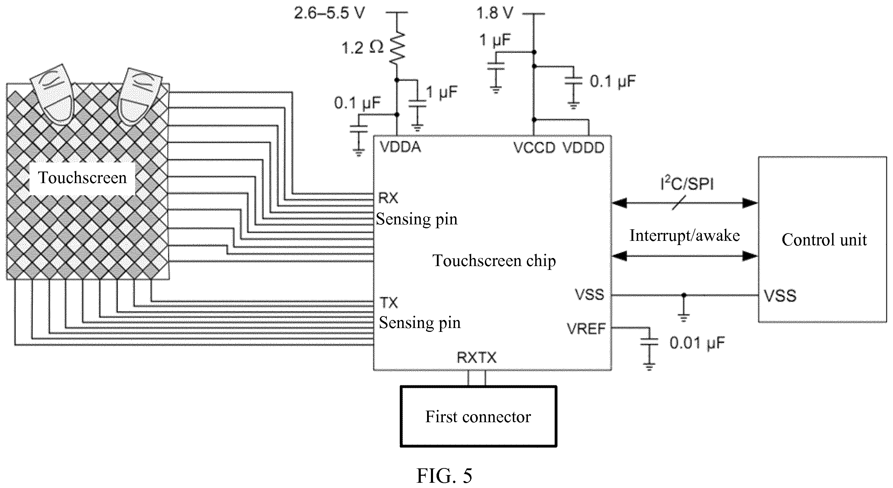

This embodiment of the present invention provides a capacitance detection apparatus, including a first touch control part, a second touch control part and a capacitance detection unit. There is an open hole between the first touch control part and the second touch control part, and the open hole is aligned to a voice transmitting hole of a microphone. Once the voice transmitting hole is blocked by an object, the capacitance detection unit detects that a capacitance value of a position in which the microphone is located increases. In this case, a touchscreen chip sends the measured capacitance value to a control unit. The control unit determines, according to the capacitance value, whether the microphone is blocked, and if yes, the control unit controls a prompt apparatus to prompt a user that the microphone is blocked. Therefore, a problem of microphone blocking is resolved, making an ongoing voice call smoother. A main difference between the capacitance detection apparatus shown in FIG. 4 and the capacitance detection apparatus shown in FIG. 2 is: The capacitance detection apparatus shown in FIG. 4 may not be separately provided with a capacitance detection unit, and but share a same chip, that is, a touchscreen chip, with a smartphone touchscreen. The touchscreen chip uses a mutual capacitance principle. Because the touchscreen chip includes multiple receive ends and transmit ends, in design of the touchscreen, one receive end and one transmit end of the touchscreen chip may be reserved for microphone anti-blocking detection. FIG. 5 is a block diagram of a principle of sharing a same touchscreen chip according to an embodiment of the present invention. As shown in FIG. 5, a receive end RX and a transmit end TX of the touchscreen chip are connected to a first connector of a capacitance detection apparatus. With reference to FIG. 4, the first connector is connected to a first touch control part and a second touch control part by using connection lines, and electrical connections between the first touch control part and the touchscreen chip and between the second touch control part and the touchscreen chip are eventually implemented.

In all of the foregoing embodiments, whether a microphone is blocked by a finger is detected according to a capacitance change. When the finger touches the microphone, the finger and a touch control unit form a simple parallel-plate capacitor. If parasitic capacitance of a capacitance detection apparatus is Cp, and finger capacitance is Cf, when the microphone is not blocked by the finger, total capacitance of the touch control unit is Cx=Cp, and when the microphone is blocked by the finger, the total capacitance of the touch control unit is Cx=Cp+Cf. Therefore, the capacitance detection apparatuses in the foregoing embodiments all detect whether a microphone is blocked according to a capacitance change.

A further embodiment of the present invention provides user equipment. The user equipment includes a switch apparatus, a control unit, a microphone, and a prompt apparatus. The switch apparatus includes an elastic part and a connecting piece. The elastic part is disposed on a housing of the user equipment, and the elastic part corresponds to a voice transmitting hole of the microphone. The connecting piece is electrically connected to the control unit. There is a gap between the elastic part and the connecting piece. When a touch object exerts pressure on the elastic part, the elastic part touches the connecting piece because of elastic deformation, and a preset level value "0" is generated. The control unit determines, according to the detected preset level value, that the microphone is blocked, and controls the prompt apparatus to send prompt information. Optionally, the prompt apparatus includes at least one of a speaker, a vibrator or a display screen on the user equipment. Therefore, the prompt information may be correspondingly a voice prompt, a vibration prompt, a text prompt or the like.

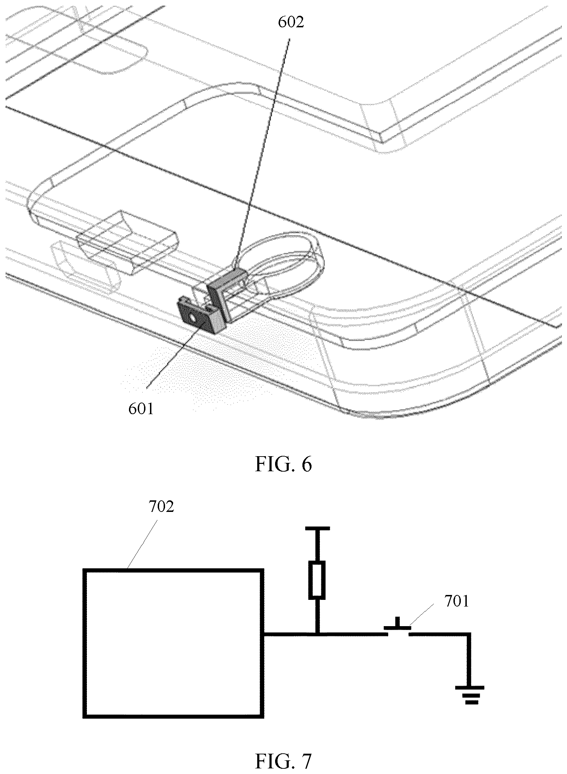

Further, FIG. 6 is a schematic diagram of cooperative use of the switch apparatus and the microphone according to the further embodiment of the present invention. As shown in FIG. 6, the switch apparatus includes an elastic part 601 and a connecting piece 602. An open hole is formed on the elastic part 601, and the open hole is aligned to the voice transmitting hole of the microphone. The elastic part 601 is fastened to a housing of the user equipment, and can be grounded reliably by using the housing. The connecting piece 602 is disposed on a mainboard of the user equipment, and is connected to a general purpose input/output (General Purpose Input Output, GPIO for short) of the control unit by using a connection line. The elastic part 601 may be a metallic elastic part, for example, an elastic part made of copper. The connecting piece 602 may be a metallic connecting piece, for example, a connecting piece made of copper. FIG. 7 is a diagram of a principle of detecting microphone blocking by using a switch apparatus according to the further embodiment of the present invention. As shown in FIG. 7, a switch apparatus 701 has one end grounded by using a housing, and the other end connected to a GPIO of a control unit 702. When the switch apparatus 701 is pressed down, that is, an elastic part touches a connecting piece, an entire circuit is grounded, that is, a voltage on the circuit is 0 V, and a corresponding logical level value is "0". In this case, the control unit 702 determines, according to the detected preset level value, that a microphone is blocked, and controls a prompt apparatus to send prompt information to a user.

It should be noted that the control unit in this embodiment of the present invention may be a central processing unit (Central Processing Unit, CPU for short).

This embodiment of the present invention provides user equipment, including: a switch apparatus, a control unit, a microphone, and a prompt apparatus, where when the microphone is blocked by a finger, the elastic part touches the connecting piece, and the control unit determines, according to a detected preset level value, that the microphone is blocked, and controls a prompt apparatus to send prompt information to a user, thereby making an ongoing voice call smoother.

Finally, it should be noted that the foregoing embodiments are merely intended for describing the technical solutions of the present invention, but not for limiting the present invention. Although the present invention is described in detail with reference to the foregoing embodiments, persons of ordinary skill in the art should understand that they may still make modifications to the technical solutions described in the foregoing embodiments or make equivalent replacements to some or all technical features thereof, without departing from the scope of the appended claims.

## Claims

1. A user equipment, comprising: a capacitance detection apparatus, a control unit, a microphone (103), and a prompt apparatus, wherein
the capacitance detection apparatus comprises a touch control unit (101) and a capacitance detection unit (105);
the touch control unit is configured to sense a capacitance change of a touch area in which the touch control unit is located, and the microphone is located in the touch area;
the capacitance detection unit is electrically connected to the touch control unit, and the capacitance detection unit measures a capacitance value of the touch area according to the capacitance change sensed by the touch control unit, and sends the capacitance value to the control unit; and
the control unit determines whether the capacitance value is greater than or equal to a first preset value, and if yes, determines that the microphone is blocked, and controls the prompt apparatus to send prompt information;
wherein an open hole is formed on the touch control unit, and the open hole is aligned to a voice transmitting hole of the microphone;
wherein the touch control unit comprises a first touch control part and a second touch control part; and
the first touch control part and the second touch control part are disposed facing each other to form an open hole, and the open hole is aligned to a voice transmitting hole of the microphone;
wherein the capacitance detection unit is a touchscreen chip, a transmit end of the touchscreen chip is electrically connected to the first touch control part, and a receive end of the touchscreen chip is electrically connected to the second touch control part.

2. The user equipment according to claim 1, further comprising a first connector, wherein
one end of the first connector is connected to the touch control unit by using a connection line, and the other end of the first connector is electrically connected to a second connector on a mainboard of the user equipment; and
the capacitance detection unit is electrically connected to the second connector.

3. The user equipment according to claim 2, wherein the touch control unit, the connection line and the first connector are laid on a flexible circuit board.

4. The user equipment according to any one of claims 1 to 3, wherein the prompt apparatus comprises at least one of a speaker, a vibrator or a display screen on the user equipment.

5. A user equipment, comprising: a switch apparatus, a control unit, a microphone, and a prompt apparatus, wherein
the switch apparatus comprises an elastic part (601) and a connecting piece (602);
the elastic part is disposed on a housing of the user equipment, and the elastic part corresponds to a voice transmitting hole of the microphone;
the connecting piece is electrically connected to the control unit;
there is a gap between the elastic part and the connecting piece, and the elastic part touches the connecting piece when a touch object exerts pressure on the elastic part, and a preset level value is generated; and
the control unit determines, according to the detected preset level value, that the microphone is blocked, and controls the prompt apparatus to send prompt information.

6. The user equipment according to claim 5, wherein an open hole is formed on the elastic part, and the open hole is aligned to the voice transmitting hole of the microphone.

7. The user equipment according to claim 5 or 6, wherein the connecting piece is connected to a general purpose input/output, GPIO, of the control unit by using a connection line.

8. The user equipment according to any one of claims 5 to 7, wherein the prompt apparatus comprises at least one of a speaker, a vibrator or a display screen on the user equipment.

## Patentansprüche

1. Teilnehmereinrichtung, die Folgendes umfasst: eine Kapazitätsdetektionsvorrichtung, eine Steuereinheit, ein Mikrofon (103) und eine Aufforderungsvorrichtung, wobei
die Kapazitätsdetektionsvorrichtung eine Berührungssteuereinheit (101) und eine Kapazitätsdetektionseinheit (105) umfasst;
die Berührungssteuereinheit dazu ausgelegt ist, eine Kapazitätsänderung eines Berührungsbereichs, in dem sich die Berührungssteuereinheit befindet, zu erfassen, und das Mikrofon sich im Berührungsbereich befindet;
die Kapazitätsdetektionseinheit mit der Berührungssteuereinheit elektrisch verbunden ist und die Kapazitätsdetektionseinheit einen Kapazitätswert des Berührungsbereichs gemäß der Kapazitätsänderung, die von der Berührungssteuereinheit erfasst wurde, misst und den Kapazitätswert an die Steuereinheit sendet und
die Steuereinheit bestimmt, ob der Kapazitätswert größer als oder gleich einem ersten voreingestellten Wert ist, und wenn ja, bestimmt, dass das Mikrofon blockiert ist, und die Aufforderungsvorrichtung steuert, um Aufforderungsinformationen zu senden;
wobei auf der Berührungssteuereinheit ein offenes Loch gebildet ist und das offene Loch auf ein Sprachübertragungsloch des Mikrofons ausgerichtet ist;
wobei die Berührungssteuereinheit einen ersten Berührungssteuerteil und einen zweiten Berührungssteuerteil umfasst und
der erste Berührungssteuerteil und der zweite Berührungssteuerteil einander zugewandt angeordnet sind, um ein offenes Loch zu bilden, und das offene Loch auf ein Sprachübertragungsloch des Mikrofons ausgerichtet ist;
wobei die Kapazitätsdetektionseinheit ein Touchscreenchip ist, ein Übertragungsende des Touchscreenchips elektrisch mit dem ersten Berührungssteuerteil verbunden ist und ein Empfangsende des Touchscreenchips elektrisch mit dem zweiten Berührungssteuerteil verbunden ist.

2. Teilnehmereinrichtung nach Anspruch 1, die ferner einen ersten Verbinder umfasst, wobei
ein Ende des ersten Verbinders unter Verwendung einer Verbindungsleitung mit der Berührungssteuereinheit verbunden ist und das andere Ende des ersten Verbinders mit einem zweiten Verbinder auf einem Mainboard der Teilnehmereinrichtung elektrisch verbunden ist und
die Kapazitätsdetektionseinheit mit dem zweiten Verbinder elektrisch verbunden ist.

3. Teilnehmereinrichtung nach Anspruch 2, wobei die Berührungssteuereinheit, die Verbindungsleitung und der erste Verbinder auf einer flexiblen Leiterplatte liegen.

4. Teilnehmereinrichtung nach einem der Ansprüche 1 bis 3, wobei die Aufforderungsvorrichtung mindestens einen Lautsprecher, einen Vibrator oder einen Anzeigebildschirm an der Teilnehmereinrichtung umfasst.

5. Teilnehmereinrichtung, die Folgendes umfasst: eine Schaltvorrichtung, eine Steuereinheit, ein Mikrofon und eine Aufforderungsvorrichtung, wobei die Schaltvorrichtung ein elastisches Teil (601) und ein Verbindungsstück (602) umfasst;
das elastische Teil auf einem Gehäuse der Teilnehmereinrichtung angeordnet ist und das elastische Teil einem Sprachübertragungsloch des Mikrofons entspricht;
das Verbindungsstück mit der Steuereinheit elektrisch verbunden ist;
zwischen dem elastischen Teil und dem Verbindungsstück ein Spalt besteht und das elastische Teil das Verbindungsstück berührt, wenn ein Berührungsobjekt Druck auf das elastische Teil ausübt und ein voreingestellter Niveauwert erzeugt wird; und
die Steuereinheit gemäß dem detektierten voreingestellten Niveauwert bestimmt, dass das Mikrofon blockiert ist, und die Aufforderungsvorrichtung steuert, um Aufforderungsinformationen zu senden.

6. Teilnehmereinrichtung nach Anspruch 5, wobei auf dem elastischen Teil ein offenes Loch gebildet ist und das offene Loch auf das Sprachübertragungsloch des Mikrofons ausgerichtet ist.

7. Teilnehmereinrichtung nach Anspruch 5 oder 6, wobei das Verbindungsstück unter Verwendung einer Verbindungsleitung mit einem universellen Eingang/Ausgang, GPIO, der Steuereinheit verbunden ist.

8. Teilnehmereinrichtung nach einem der Ansprüche 5 bis 7, wobei die Aufforderungsvorrichtung mindestens einen Lautsprecher, einen Vibrator oder einen Anzeigebildschirm an der Teilnehmereinrichtung umfasst.

## Revendications

1. Équipement d'utilisateur comprenant : un appareil de détection de capacité, une unité de commande, un microphone (103) et un appareil de sollicitation, dans lequel l'appareil de détection de capacité comprend une unité de commande tactile (101) et une unité de détection de capacité (105) ;
l'unité de commande tactile est configurée pour détecter un changement de capacité d'une zone tactile dans laquelle l'unité de commande tactile est située, et le microphone est situé dans la zone tactile ;
l'unité de détection de capacité est raccordée électriquement à l'unité de commande tactile et l'unité de détection de capacité mesure une valeur de capacité de la zone tactile en fonction du changement de capacité détecté par l'unité de commande tactile, et envoie la valeur de capacité à l'unité de commande ; et
l'unité de commande détermine si la valeur de capacité est supérieure ou égale à une première valeur prédéfinie et, si tel est le cas, détermine que le microphone est bloqué et commande l'appareil de sollicitation pour envoyer un message de sollicitation ;
dans lequel un trou ouvert est formé sur l'unité de commande tactile et le trou ouvert est aligné sur un trou de transmission de la voix du microphone ;
dans lequel l'unité de commande tactile comprend une première partie de commande tactile et une seconde partie de commande tactile ; et
la première partie de commande tactile et la seconde partie de commande tactile sont disposées l'une en face de l'autre pour former un trou ouvert et le trou ouvert est aligné sur un trou de transmission de la voix du microphone ;
dans lequel l'unité de détection de capacité est une puce d'écran tactile, une extrémité de transmission de la puce d'écran tactile est raccordée électriquement à la première partie de commande tactile et une extrémité de réception de la puce d'écran tactile est raccordée électriquement à la seconde partie de commande tactile.

2. Équipement d'utilisateur selon la revendication 1, comprenant en outre un premier connecteur, dans lequel
une extrémité du premier connecteur est raccordée à l'unité de commande tactile en utilisant une ligne de connexion et l'autre extrémité du premier connecteur est raccordée électriquement à un second connecteur sur une carte mère de l'équipement d'utilisateur ; et
l'unité de détection de capacité est raccordée électriquement au second connecteur.

3. Équipement d'utilisateur selon la revendication 2, dans lequel l'unité de commande tactile, la ligne de connexion et le premier connecteur sont disposés sur une carte de circuit imprimé souple.

4. Équipement d'utilisateur selon l'une quelconque des revendications 1 à 3, dans lequel l'appareil de sollicitation comprend un haut-parleur et/ou un vibreur et/ou un écran d'affichage sur l'équipement d'utilisateur.

5. Équipement d'utilisateur comprenant : un appareil de commutation, une unité de commande, un microphone et un appareil de sollicitation, dans lequel
l'appareil de commutation comprend une partie élastique (601) et une pièce de liaison (602) ;
la partie élastique est disposée sur un boîtier de l'équipement d'utilisateur et la partie élastique correspond à un trou de transmission de la voix du microphone ;
la pièce de liaison est raccordée électriquement à l'unité de commande ;
il existe un espace entre la partie élastique et la pièce de liaison et la partie élastique touche la pièce de liaison lorsqu'un objet tactile exerce une pression sur la partie élastique et une valeur de niveau prédéfinie est générée ; et
l'unité de commande détermine, en fonction de la valeur de niveau prédéfinie détectée, que le microphone est bloqué, et commande l'appareil de sollicitation pour envoyer des informations de sollicitation.

6. Équipement d'utilisateur selon la revendication 5, dans lequel un trou ouvert est formé sur la partie élastique et le trou ouvert est aligné sur le trou de transmission de la voix du microphone.

7. Équipement d'utilisateur selon la revendication 5 ou 6, dans lequel la pièce de liaison est raccordée à une entrée/sortie universelle, GPIO, de l'unité de commande en utilisant une ligne de connexion.

8. Équipement d'utilisateur selon l'une quelconque des revendications 5 à 7, dans lequel l'appareil de sollicitation comprend un haut-parleur et/ou un vibreur et/ou un écran d'affichage sur l'équipement d'utilisateur.
